# EUROPEAN PATENT SPECIFICATION

(11) **EP 4 513 279 B1**
(45) Date of publication and mention of the grant of the patent: **08.07.2026**
(21) Application number: 23846767.4
(22) Date of filing: 19.05.2023
(51) Int. Cl.: G04G 17/04, G04G 17/08, F16B 23/00, G06F 1/18, G06F 1/20

(54) **ELECTRONIC DEVICE COMPRISING STACKED SCREW STRUCTURE**
ELEKTRONISCHE VORRICHTUNG MIT GESTAPELTER SCHRAUBENSTRUKTUR
DISPOSITIF ÉLECTRONIQUE COMPRENANT UNE STRUCTURE DE VIS EMPILÉE

(30) Priority: 29.07.2022 KR 20220094481; 18.08.2022 KR 20220103153
(43) Date of publication of application: 26.02.2025
(73) Proprietor: Samsung Electronics Co., Ltd., Suwon-si, Gyeonggi-do 16677 (KR)
(72) Inventor: CHOI, Bongsuk, Suwon-si Gyeonggi-do 16677 (KR); JUNG, Soli, Suwon-si Gyeonggi-do 16677 (KR)
(74) Representative: HGF
(86) International application number: PCT/KR2023/006836
(87) International publication number: WO 2024/025106

(56) References cited:
- EP-B1- 1 081 994
- JP-A- 2012 150 101
- KR-A- 20150 077 304
- KR-B1- 100 380 130
- KR-Y1- 200 207 451
- US-A1- 2010 247 270

## Description

### BACKGROUND

### Field

Various embodiments of the present disclosure relate to an electronic device including a stacked screw structure.

### Description of Related Art

The development of electronic technology has accelerated the development and distribution of various types of electronic products. For example, the distribution of an electronic device that may be worn on the body, such as a wearable electronic device, is expanding. In addition, to miniaturize an electronic device, a method of efficiently using an internal disposition space is being researched and developed.

EP 1081994B1 discloses, according to its abstract, that an improved securement device aligns adjacent printed circuit boards ("PCBs") while simultaneously connecting all external hardware so as to prevent over-compression of elastomeric contacts positioned therebetween during assembly. The device supports a connector between a pair of PCBs in spaced parallel relation, wherein the connector itself supports a plurality of elastomeric contacts thereon for establishing electrical engagement between the PCBs. The PCBs and the connector each include aligned securement openings. The device includes an elongate fastener having a substantially cylindrical section positioned in the connector opening. The cylindrical section defines a pair of opposed, substantially planar spaced apart component landings for support of a similarly planar component thereupon. The landings are spaced apart a distance sufficient to place the PCBs in communication with the connector without over-compressing the elastomeric contacts therebetween. A substantially annular shoulder is concentrically defined on each of the landings and extends longitudinally therefrom. Such shoulder has an outer diameter smaller than an outer diameter of said cylindrical section. Further, a fastening element extends longitudinally from at least one of said top and bottom shoulders for fastening of the securement element to a housing member accommodating the PCBs and connector therein. In a preferred example, a diametrical slotted cavity is defined in one landing and shoulder, which accommodates a torquing element therein. The slotted cavity provides access to an internally threaded bore which is defined along the length of the slot and can be defined along the longitudinal extent of the cylindrical section itself.
KR100380130B1 discloses, according to its abstract, that the members of the assembly of the first member with a hole and the second member of a deformable sheet-type material are perforated and deformed by means of a punch and die to provide a perforated hole with an external main wall of a helical shape similar to a thread, the members are assembled together so that the holes are aligned, and a tubular fastener with a head and shank is inserted into the hole so that the head is in contact with the face of the first member and the shank extends through the second member. Then, by expanding at least part of the shank from the drilled hole of the second member, the outer curb wall of the perforated hole is fastened together by imprinting a helical outer circumference on the outer surface of the shank of the fastener. The shank can be inflated by pulling the tapered mandrel head inside the shank. Fasteners are designed to be easily removed by turning the screw in the fastened assembly by providing or forming a wrenching surface in the bore that engages with a key, screwdriver, spanner, etc., or on the fastener head.

### SUMMARY

The scope of the present invention is determined according to the independent claim.

Various embodiments of the present invention are outlined in the dependent claims.

Also disclosed herein is that an electronic device 300 includes a first housing 311 in which a first screw insertion hole 3111 is formed, a second housing 312 capable of being fastened to the first housing 311, a first screw 410 including a head 411, a second screw insertion hole 413 formed in the head 411, and a first concave-convex structure 414 formed around the second screw insertion hole 413 and configured to penetrate a target component 320 and be inserted into the first screw insertion hole 3111 to fix the target component 320 to the first housing 311, a second screw 420 configured to penetrate the second housing 312 and be inserted into the second screw insertion hole 413 to fix the second housing 312 to the first housing 311, and a second concave-convex structure 443 positioned between the head 411 of the first screw 410 and the second housing 312 and corresponding to the first concave-convex structure 414.

Also disclosed herein is that a wearable electronic device 300 includes a first housing 311 in which a first screw insertion hole 3111 is formed and configured to form a rear surface of the electronic device 300, a second housing 312 capable of being fastened to the first housing 311 and configured to form a side surface of the electronic device 300, a front plate 313 connected to the second housing 312 and configured to form a front surface of the electronic device 300, a first screw 410 including a head 411, a second screw insertion hole 413 formed in the head 411, and a first concave-convex structure 414 formed around the second screw insertion hole 413 and configured to penetrate a target component 320 and be inserted into the first screw insertion hole 3111 to fix the target component 320 to the first housing 311, a second screw 420 configured to penetrate the second housing 312 and be inserted into the second screw insertion hole 413to fix the second housing 312 to the first housing 311, and a second concave-convex structure 443 positioned between the head 411 of the first screw 410 and the second housing 312 and corresponding to the first concave-convex structure 414.

Also disclosed herein is that an electronic device 300 includes a first housing 311 in which a first screw insertion hole 3111 is formed, a second housing 312 capable of being fastened to the first housing 311, a first screw 410 including a head 411, a second screw insertion hole 413 formed in the head 411, and a first concave-convex structure 414 formed around the second screw insertion hole 413 and configured to penetrate a target component 320 and be inserted into the first screw insertion hole 3111 to fix the target component 320 to the first housing 311, a second screw 420 configured to penetrate the second housing 312 and be inserted into the second screw insertion hole 413 to fix the second housing 312 to the first housing 311, a heat dissipation member 430 including a main heat dissipation body 431 and an extended heat dissipation body 432 extending from the main heat dissipation body 431 and disposed such that one surface contacts the second housing 312 and another surface faces the head 411 of the first screw 410, a second concave-convex structure 443 corresponding to the first concave-convex structure 414, and a concave-convex member 440 positioned in the other surface of the extended heat dissipation body 432. The first concave-convex structure 414 and the second concave-convex structure 443 are positioned spaced apart from each other in a state in which the first screw 410 is completely fastened to the first screw insertion hole 3111. The rotation of the first screw 410 is limited in a state in which the first concave-convex structure 414 and the second concave-convex structure 443 are engaged with each other when the first screw 410 is dismantled from the first screw insertion hole 3111 by a designated length.

### BRIEF DESCRIPTION OF THE DRAWINGS

FIG. 1 is a block diagram of an electronic device in a network environment, according to an embodiment.
FIG. 2A is a front perspective view of an electronic device according to an embodiment.
FIG. 2B is a rear perspective view of an electronic device according to an embodiment.
FIG. 3 is an exploded perspective view of an electronic device according to an embodiment.
FIG. 4A is a plan view illustrating a state in which a target component is fixed to a first housing by a first screw, according to an embodiment.
FIG. 4B is a perspective view of a first screw according to an embodiment.
FIG. 4C is a plan view illustrating a state in which a heat dissipation member is positioned on a target component in the state of FIG. 4A, according to an embodiment.
FIG. 4D is a rear perspective view of a heat dissipation member according to an embodiment.
FIG. 4E is a plan view illustrating a state in which a second housing and a heat dissipation member are fixed to a first housing by a second screw in the state of FIG. 4C, according to an embodiment.
FIG. 4F is a cross-sectional view taken along line A-A of FIG. 4E, according to an embodiment.
FIG. 4G is a cross-sectional view taken along line B-B of FIG. 4E, according to an embodiment.
FIG. 4H illustrates a state in which a second screw and a first screw are each dismantled by a predetermined length in the state of FIG. 4F, according to an embodiment.
FIG. 5 is a cross-sectional view of an electronic device according to an embodiment.

### DETAILED DESCRIPTION

Hereinafter, embodiments will be described in detail with reference to the accompanying drawings. When describing the embodiments with reference to the accompanying drawings, like reference numerals refer to like elements and a repeated description related thereto will be omitted.

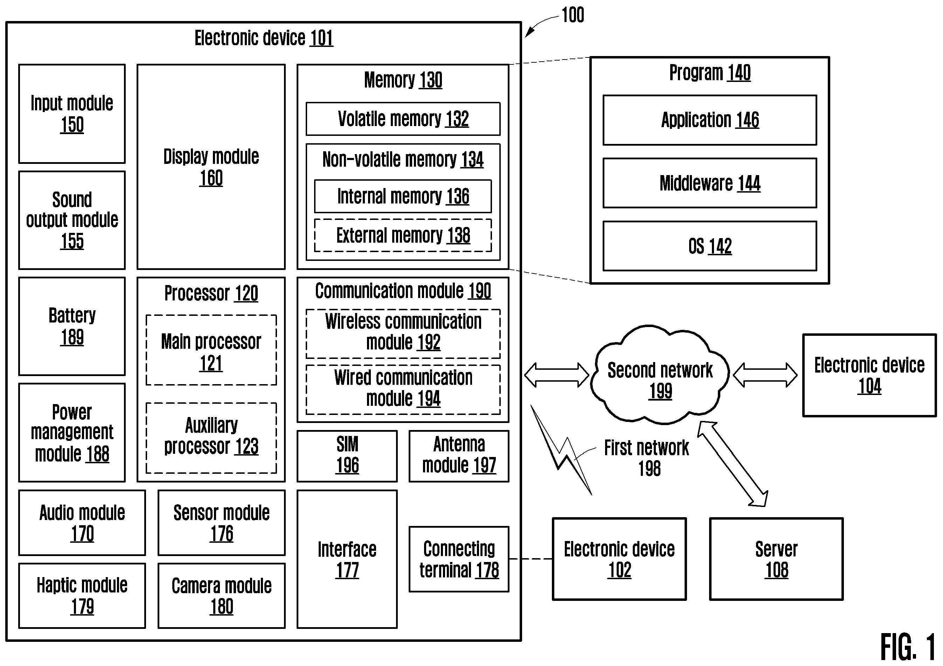

FIG. 1 is a block diagram of an electronic device 101 in a network environment 100, according to an embodiment. Referring to FIG. 1, the electronic device 101 in the network environment 100 may communicate with an electronic device 102 via a first network 198 (e.g., a short-range wireless communication network), or communicate with at least one of an electronic device 104 and a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, and a sensor module 176, an interface 177, a connecting terminal 178, a haptic module 179, a camera module 180, a motor 187, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added to the electronic device 101. In some embodiments, some of the components (e.g., the sensor module 176, the camera module 180, or the antenna module 197) may be integrated as a single component (e.g., the display module 160).

The processor 120 may execute, for example, software (e.g., a program 140) to control at least one other component (e.g., a hardware or software component) of the electronic device 101 connected to the processor 120 and may perform various data processing or computations. According to an embodiment, as at least a part of data processing or computations, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specifically for artificial intelligence model processing. An artificial intelligence model may be generated by machine learning. The machine learning may be performed by, for example, the electronic device 101, in which artificial intelligence is performed, or performed via a separate server (e.g., the server 108). Learning algorithms may include, but are not limited to, for example, supervised learning, unsupervised learning, semi-supervised learning, or reinforcement learning. The artificial intelligence (AI) model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The AI model may additionally or alternatively include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive, from outside (e.g., a user) the electronic device 101, a command or data to be used by another component (e.g., the processor 120) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control its corresponding one of the display, the hologram device, and the projector. According to an embodiment, the display module 160 may include a touch sensor adapted to detect a touch, or a pressure sensor adapted to measure the intensity of force of the touch.

The audio module 170 may convert sound into an electric signal or vice versa. According to an embodiment, the audio module 170 may obtain the sound via the input module 150 or output the sound via the sound output module 155 or an external electronic device (e.g., the electronic device 102, such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101 and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used by the electronic device 101 to couple with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may physically connect to an external electronic device (e.g., the electronic device 102). According to an embodiment, the connecting terminal 178 may include, for example, an HDMI connector, a USB connector, an SD card connector, or an audio connector (e.g., a headphones connector).

The haptic module 179 may convert an electric signal into a mechanical stimulus (e.g., a vibration or a movement) or an electrical stimulus, which may be recognized by a user via their tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, and flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell, which is not rechargeable, a secondary cell, which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., an AP) and that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device, for example, the electronic device 104, via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., an antenna array). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to various embodiments, the antenna module 197 may form a mmWave antenna module. According to an embodiment, the mmWave antenna module may include a PCB, an RFIC on a first surface (e.g., the bottom surface) of the PCB, or adjacent to the first surface of the PCB and capable of supporting a designated high-frequency band (e.g., a mmWave band), and a plurality of antennas (e.g., array antennas) disposed on a second surface (e.g., the top or a side surface) of the PCB, or adjacent to the second surface of the PCB and capable of transmitting or receiving signals of the designated high-frequency band.

At least some of the above-described components may be coupled mutually and exchange signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device (e.g., the electronic device 104) via the server 108 coupled with the second network 199. Each of the external electronic devices (e.g., the electronic device 102 or 104) may be a device of the same type as or a different type from the electronic device 101. According to an embodiment, all or some of operations to be executed by the electronic device 101 may be executed by one or more external electronic devices (e.g., the electronic devices 102 and 104 and the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or service. The one or more external electronic devices receiving the request may perform the at least part of the function or service, or an additional function or an additional service related to the request and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra low-latency services using, e.g., distributed computing or MEC. In an embodiment, the external electronic device (e.g., the electronic device 104) may include an Internet-of-things (IoT) device. The server 108 may be an intelligent server using machine learning and/or a neural network. According to an embodiment, the external electronic device (e.g., the electronic device 104) or the server 108 may be included in the second network 199. The electronic device 101 may be applied to intelligent services (e.g., a smart home, a smart city, a smart car, or healthcare) based on 5G communication technology or IoT-related technology.

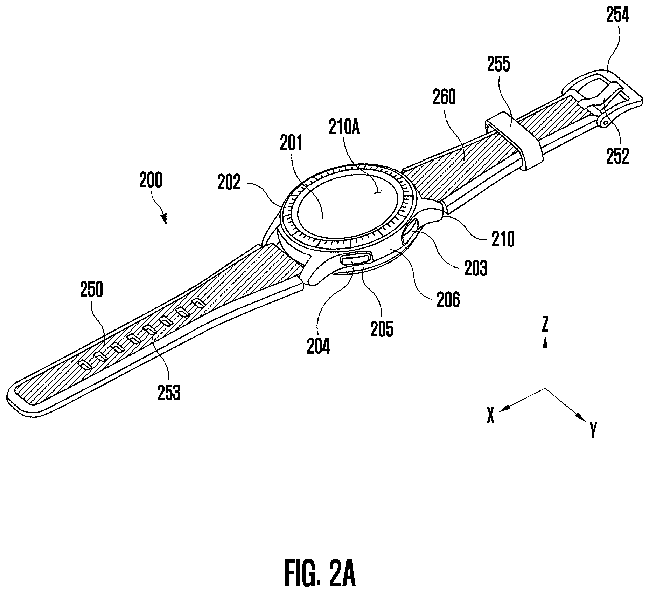

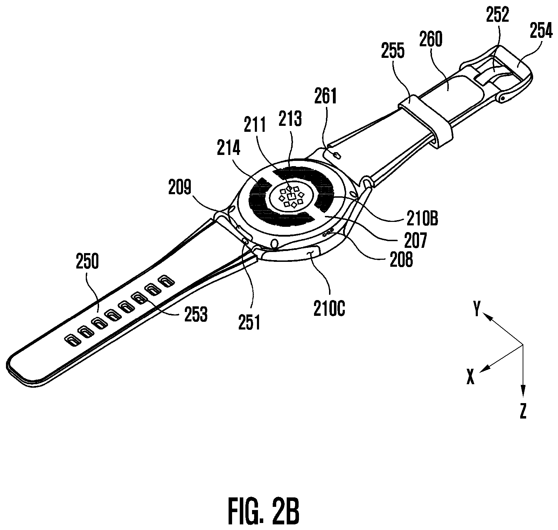

FIG. 2A is a front perspective view of an electronic device according to an embodiment. FIG. 2B is a rear perspective view of an electronic device according to an embodiment.

Referring to FIGS. 2A and 2B, according to an embodiment, an electronic device 200 (e.g., the electronic device 101 of FIG. 1) may include a housing 210 including a first surface (or a front surface) 210A, a second surface (or a rear surface) 210B, and a side surface 210C surrounding a space between the first surface 210A and the second surface 210B, and fastening members 250 and 260 connected to at least a portion of the housing 210 and configured to detachably attach the electronic device 200 to a body part (e.g., the wrist, the ankle, etc.) of a user. In another embodiment (not shown), a housing may also refer to a structure which forms a portion of the first surface 210A, the second surface 210B, and the side surface 210C of FIG. 2A. According to an embodiment, the first surface 210A may be formed by a front plate 201 (e.g., a glass plate or a polymer plate including various coating layers) of which at least a portion is substantially transparent. The second surface 210B may be formed of a rear plate 207 that is substantially opaque. The rear plate 207 may be formed of, for example, coated or colored glass, ceramic, polymer, metal (e.g., aluminum, stainless steel (SS), or magnesium), or a combination of at least two thereof. The side surface 210C may be coupled to the front plate 201 and the rear plate 207 and may be formed by a side bezel structure (or a "side member") 206 including a metal and/or a polymer. In an embodiment, the rear plate 207 and the side bezel structure 206 may be integrally formed and may include the same material (e.g., a metal material such as aluminum). The fastening members 250 and 260 may be formed of various materials and may have various shapes. The fastening members 250 and 260 may be formed of woven fabric, leather, rubber, urethane, metal, ceramic, or a combination of at least two of the aforementioned materials and may be implemented in an integrated form or with a plurality of unit links that are movable relative to each other.

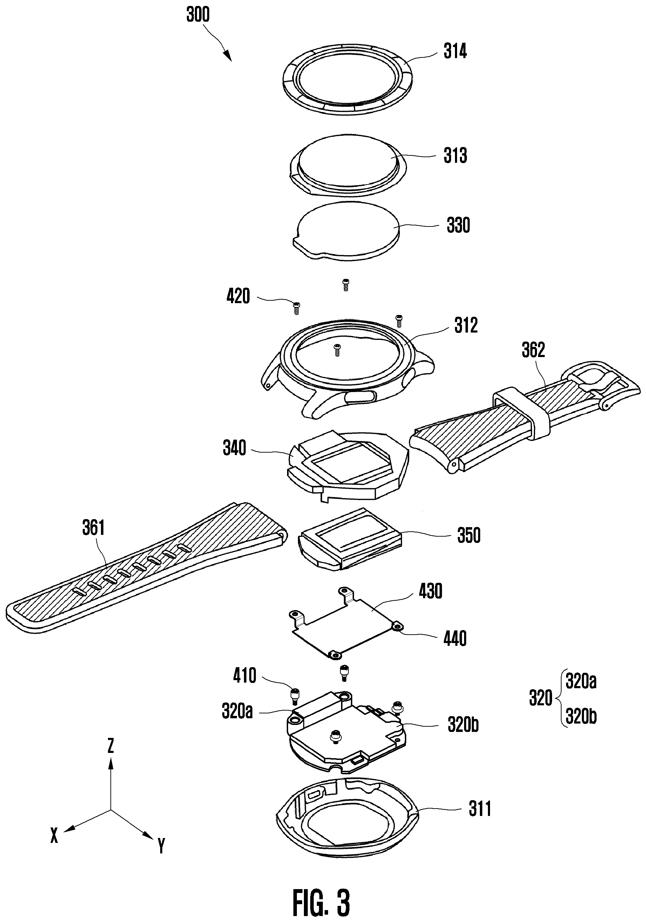

According to an embodiment, the electronic device 200 may include at least one of a display (e.g., a display 330 of FIG. 3), audio modules 205 and 208, a sensor module 211, key input devices 202, 203, and 204, and a connector hole 209. In an embodiment, the electronic device 200 may not include at least one (e.g., the key input devices 202, 203, and 204, the connector hole 209, or the sensor module 211) of the components or additionally include other components.

The audio modules 205 and 208 may include a microphone hole 205 and a speaker hole 208. A microphone for acquiring external sound may be disposed in the microphone hole 205. In an embodiment, a plurality of microphones may be disposed to detect a direction of sound. The speaker hole 208 may be used as an external speaker and a call receiver for calls. In an embodiment, the speaker hole 208 and the microphone hole 205 may be implemented as a single hole, or a speaker (e.g., a piezo speaker) may be included without the speaker hole 208.

The sensor module 211 may generate an electrical signal or a data value corresponding to an internal operating state of the electronic device 200 or an external environmental state. The sensor module 211 may include, for example, a biometric sensor module 211 (e.g., a heart rate monitor (HRM) sensor) disposed on the second surface 210B of the housing 210. The electronic device 200 may further include at least one of sensor modules (not shown), for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, and an illuminance sensor.

The sensor module 211 may include electrode areas 213 and 214 that form a portion of the surface of the electronic device 200 and a biosignal detection circuit (not shown) electrically connected to the electrode areas 213 and 214. For example, the electrode areas 213 and 214 may include a first electrode area 213 and a second electrode area 214 disposed on the second surface 210B of the housing 210. The sensor module 211 may be configured such that the electrode areas 213 and 214 obtain an electrical signal from a body part of the user, and the biosignal detection circuit detects biometric information of the user based on the electrical signal.

The key input devices 202, 203, and 204 may include a wheel key 202 disposed on the first surface 210A of the housing 210 and rotatable in at least one direction, and/or side key buttons 203 and 204 disposed on the side surface 210C of the housing 210. The wheel key may have a shape corresponding to the shape of the front plate 201. In an embodiment, the electronic device 200 may not include some or all of the above-described key input devices 202, 203, and 204, and the key input devices 202, 203, and 204 that are not included may be implemented in other forms such as soft keys on the display (e.g., the display 330 of FIG. 3)). The connector hole 209 may include another connector hole (not shown) that accommodates a connector (e.g., a universal serial bus (USB) connector) for transmitting and receiving power and/or data to and from an external electronic device and accommodates a connector for transmitting and receiving an audio signal to and from an external electronic device. The electronic device 200 may further include, for example, a connector cover (not shown) that covers at least a portion of the connector hole 209 and blocks infiltration of external foreign materials into the connector hole.

The fastening members 250 and 260 may be detachably fastened to at least a partial area of the housing 210 using locking members 251 and 261. The fastening members 250 and 260 may include one or more of a fixing member 252, a fixing member fastening hole 253, a band guide member 254, and a band fixing ring 255.

The fixing member 252 may be configured to fix the housing 210 and the fastening members 250 and 260 to a part (e.g., the wrist, the ankle, etc.) of the user's body. The fixing member fastening hole 253 may correspond to the fixing member 252 to fix the housing 210 and the fastening members 250 and 260 to the part of the user's body. The band guide member 254 may be configured to limit a range of a movement of the fixing member 252 when the fixing member 252 is fastened to the fixing member fastening hole 253 so that the fastening members 250 and 260 may be fastened to the part of the user's body in a state of being brought into close contact with the part of the user's body. The band fixing ring 255 may limit a range of a movement of the fastening members 250 and 260 in a state in which the fixing member 252 and the fixing member fastening hole 253 are fastened with each other.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be understood that various embodiments of the present disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., the internal memory 136 or the external memory 138) that is readable by a machine (e.g., the electronic device 101). For example, a processor (e.g., the processor 120) of the machine (e.g., the electronic device 101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as a memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

FIG. 3 is an exploded perspective view of an electronic device according to an embodiment.

Referring to FIG. 3, an electronic device 300 according to an embodiment may be a wearable device that is detachable to a part of the body. The electronic device 300 (e.g., the electronic device 101 of FIG. 1 and/or the electronic device 200 of FIG. 2) may include a first housing 311 (e.g., the rear plate 207 of FIG. 2B), a second housing 312 (e.g., the side bezel structure 206 of FIG. 2A), a front plate 313 (e.g., the front plate 201 of FIG. 2A), a wheel key 314 (e.g., the wheel key 202 of FIG. 2A), a target component 320, the display 330 (e.g., the display module 160 of FIG. 1), a support member 340 (e.g., a bracket), a battery 350, fastening members 361 and 362 (e.g., the fastening members 250 and 260 of FIGS. 2A and 2B), a first screw 410, a second screw 420, a heat dissipation member 430, and a concave-convex member 440. At least one of the components of the electronic device 300 may be the same as or similar to at least one of the components of the electronic device 101 of FIG. 1 or the electronic device 200 of FIGS. 2A and 2B, so repeated description thereof is omitted.

In an embodiment, the first housing 311, the second housing 312, and/or the front plate 313 may form at least a portion of the exterior of the electronic device 300. For example, the first housing 311 may form the rear exterior (e.g., a surface in a -z direction) of the electronic device 300. For example, the second housing 312 may form the side exterior (e.g., a surface in a x/y direction) of the electronic device 300. For example, the second housing 312 may be fastened to the first housing 311. For example, the front plate 313 may form the front exterior (e.g., a surface in a +z direction) of the electronic device 300. For example, the front plate 313 may be connected to the second housing 12. However, this is an example, and the exterior of the electronic device 300 formed by the first housing 311, the second housing 312, and/or the front plate 313 is not limited thereto. The first housing 311, the second housing 312, and/or the front plate 313 may be connected to each other and form a space for disposing various components therein.

In an embodiment, the wheel key 314 may be disposed in an external front surface (e.g., the surface in the +z direction) of the electronic device 300. The wheel key 314 may rotate in at least one direction.

In an embodiment, the display 330 may visually display information. The display 330 may be disposed toward the front surface (e.g., the surface in the +z direction) of the electronic device 300. For example, the display 330 may be connected to the second housing 312. The display 330 may be visible through at least a portion of the front plate 313. The shape of the display 320 may correspond to the shape of the front plate 313 and may have various shapes such as circular, elliptical, or polygonal. The display 320 may be combined with or disposed adjacent to a touch detection circuit, a pressure sensor capable of measuring the intensity (pressure) of a touch, and/or a fingerprint sensor.

In an embodiment, the support member 340 may be disposed inside the electronic device 300 and connected to the second housing 312 or may be formed integrally with the second housing 312. The support member 340 may be formed of, for example, a metallic material and/or a non-metallic (e.g., polymer) material. Various components may be disposed and supported in the support member 340.

In an embodiment, the battery 350 may supply power to at least one component of the electronic device 300. For example, the battery 350 may include a primary battery, a secondary battery, or a fuel cell. The battery 350 may be integrally disposed in the electronic device 300 or may be detachably disposed in the electronic device 300. For example, the battery 350 may be positioned in the rear direction (e.g., a -z direction) of the support member 340. However, this is an example, and the position of the battery 350 is not limited thereto.

In an embodiment, the target component 320 may be a component disposed inside the electronic device 300. The target component 320 may be fixed inside the electronic device 300 by the first screw 410 described below. For example, the target component 320 may include any one or more or a combination of a speaker, a microphone, a PCB, a bracket, a camera, a motor, or other electrical components. However, the target component 320 described above is an example, and the target component 320 is not limited thereto. Hereinafter, as an example, a case in which the target component 320 includes an audio module 320a and a PCB 320b is described.

In an embodiment, the audio module 320a (e.g., the audio module 170 of FIG. 1) may be disposed inside the electronic device 300. The audio module 320a may convert sound into an electrical signal, or conversely, may convert an electrical signal into sound. For example, the audio module 320a may obtain sound or output sound. For example, the audio module 320a may be electrically connected to the PCB 320b.

In an embodiment, the PCB 320b may be equipped with a processor, a memory, and/or an interface. The processor may include, for example, one or more of a CPU, an application processor (AP), a GPU, an AP sensor processor, or a communication processor. The memory may include, for example, a volatile memory or a non-volatile memory. The interface may include, for example, a high-definition multimedia interface (HDMI), a USB interface, a secure digital (SD) card interface, or an audio interface. For example, the interface may electrically or physically connect the electronic device 300 to an external electronic device and may include a USB connector, an SD card/multimedia card (MMC) connector, or an audio connector.

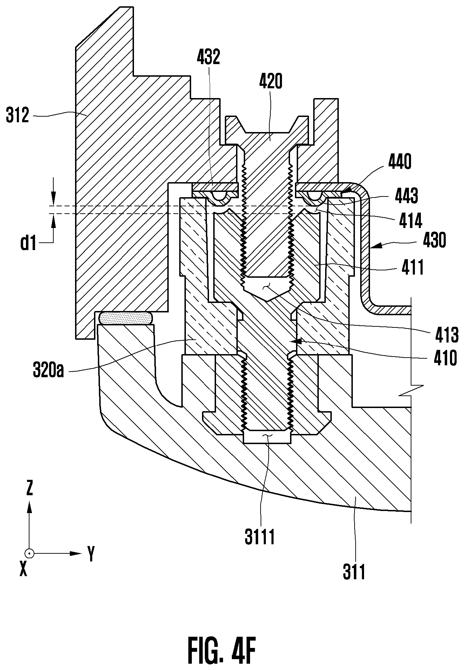

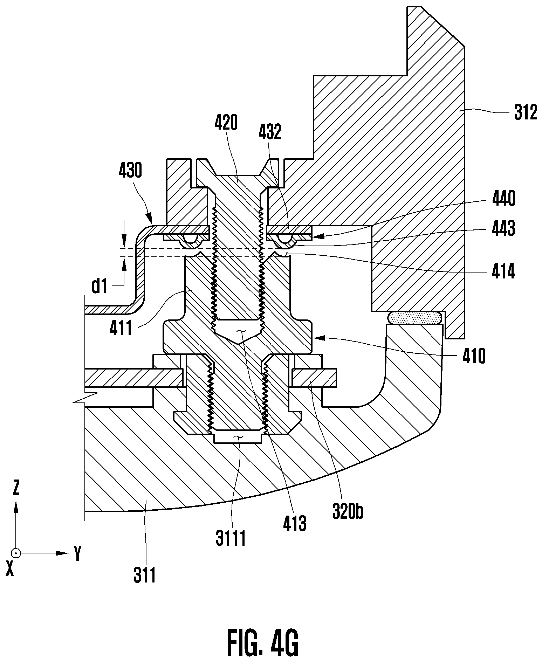

In an embodiment, the first screw 410 may fix the target component 320 to the first housing 311. For example, the first screw 410 may fix the audio module 320a and the PCB 320b to the first housing 311. The first screw 410 may be inserted into and fastened to a first screw insertion hole (e.g., a first screw insertion hole 3111 of FIGS. 4F and 4G). The first screw 410 may be provided in a number corresponding to that of the first screw insertion hole 3111. For example, the thickness of the first screw 410 may be about 1.4 millimeters (mm). However, this is an example, and the thickness of the first screw 410 is not limited thereto. The specific structure of the first screw 410 is described below.

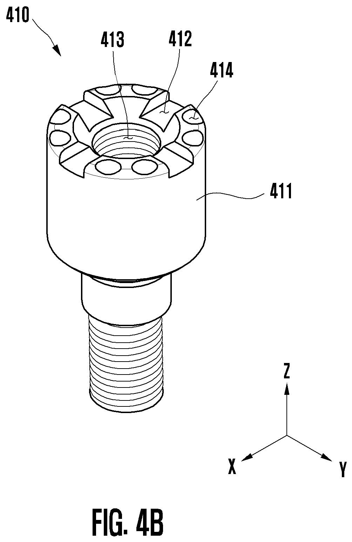

In an embodiment, the second screw 420 may fix the second housing 312 and/or the heat dissipation member 430 to the first housing 311. The second screw 420 may be provided in a number corresponding to that of the first screw 410. For example, the thickness of the second screw 420 may be about 1.2 mm. However, this is an example, and the thickness of the second screw 420 is not limited thereto. The first screw 410 and the second screw 420 may be formed in a stacked screw structure in which the first screw 410 and the second screw 420 are stacked and fastened to each other. For example, the second screw 420 may be inserted into and fastened to a second screw insertion hole (e.g., a second screw insertion hole 413 of FIG. 4B) formed in a screw head (e.g., a screw head 411 of FIG. 4B) of the first screw 410. According to the stacked screw structure, the internal space of the electronic device 300 may be efficiently used. An embodiment of a specific connection relationship between the first screw 410 and the second screw 420 is described below.

In an embodiment, the heat dissipation member 430 may be configured to dissipate heat inside the electronic device 300 outwardly. For example, the heat dissipation member 430 may be formed of a material having high thermal conductivity. The heat dissipation member 430 may form a heat transfer path for dissipating heat inside the electronic device 300 outwardly. For example, at least a portion of the heat dissipation member 430 may be positioned adjacent to or in contact with a heat-generating component inside the electronic device 300, and another portion may be positioned adjacent to or in contact with the first housing 311 and/or the second housing 312 that is in contact with the outside of the electronic device 300.

Moreover, FIG. 3 is an example, and the configuration of the electronic device 300 according to an embodiment is not limited to the configuration illustrated in FIG. 3. In addition, the position of each component of the electronic device 300 is not limited to the position illustrated in FIG. 3.

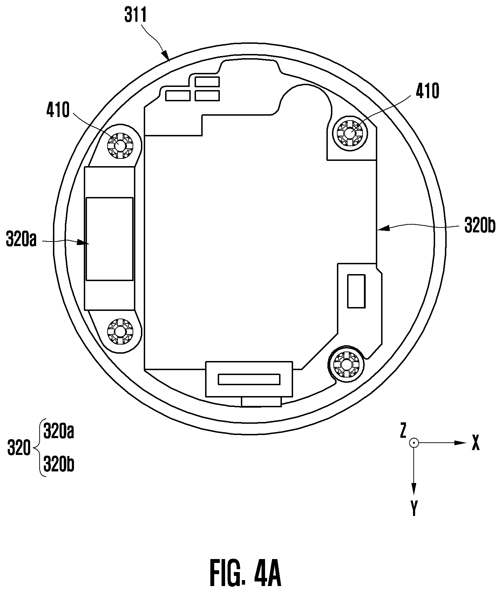

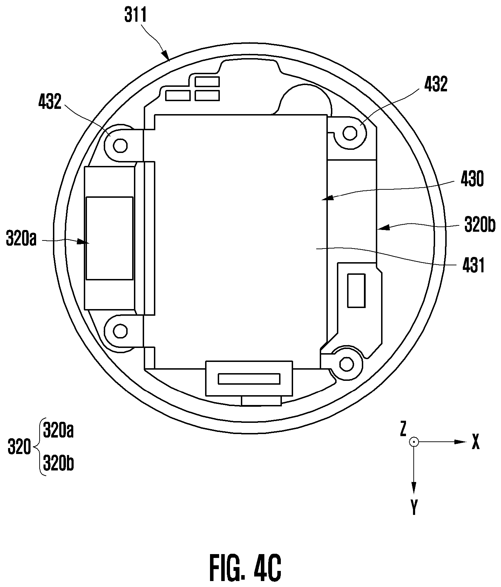

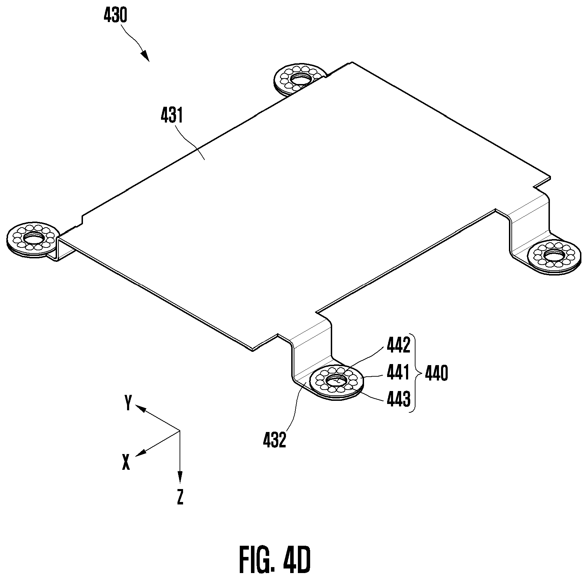

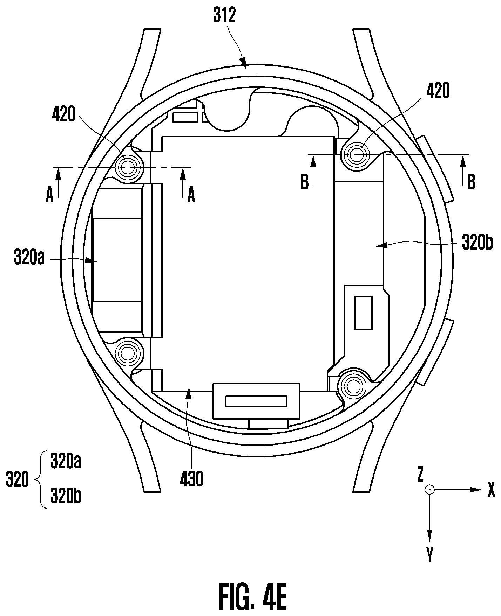

FIG. 4A is a plan view illustrating a state in which a target component is fixed to a first housing by a first screw, according to an embodiment. FIG. 4B is a perspective view of a first screw according to an embodiment. FIG. 4C is a plan view illustrating a state in which a heat dissipation member is positioned on a target component in the state of FIG. 4A, according to an embodiment. FIG. 4D is a rear perspective view of a heat dissipation member according to an embodiment. FIG. 4E is a plan view illustrating a state in which a second housing and a heat dissipation member are fixed to a first housing by a second screw in the state of FIG. 4C, according to an embodiment. FIG. 4F is a cross-sectional view taken along line A-A of FIG. 4E, according to an embodiment. FIG. 4G is a cross-sectional view taken along line B-B of FIG. 4E, according to an embodiment.

Referring to FIGS. 4A, 4B, 4F, and 4G, in an embodiment, at least one first screw 410 may fix the target component 320 (e.g., the audio module 320a and/or the PCB 320b) to the first housing 311. The first screw insertion hole 3111 into which the first screw 410 may be inserted may be formed in the first housing 311. At least one first screw insertion hole 3111 may be formed. For example, four first screw insertion holes 3111 may be formed. However, this is an example, and the number of first screw insertion holes 3111 is not limited thereto. The first screw insertion hole 3111 may be formed to have a size corresponding to that of the first screw 410. The first screw insertion hole 3111 may be positioned in the inner area of the first housing 311. For example, the first screw insertion hole 3111 may be positioned inside a space defined by the first housing 311 and a second housing (e.g., the second housing 312 of FIG. 3). According to this structure, in a state in which an electronic device (e.g., the electronic device 300 of FIG. 3) is completely assembled, the first screw 410 inserted into the first screw insertion hole 3111 may not be exposed outwardly and may be positioned inside a space defined by the first housing 311, the second housing 312, and a front plate (e.g., the front plate 313 of FIG. 3).

In an embodiment, a through hole through which the first screw 410 may penetrate may be formed in the target component 320 (e.g., the audio module 320a and/or the PCB 320b). For example, at least one through hole may be formed in the target component 320. The first screw 410 may penetrate the target component 320 and be inserted into the first screw insertion hole 3111 such that the target component 320 is fixed to the first housing 311.

In an embodiment, the first screw 410 may include the screw head 411, a screw groove 412, the second screw insertion hole 413, and a first concave-convex structure 414.

In an embodiment, the screw head 411 may refer to a head part of the first screw 410. At least one of the screw groove 412, the second screw insertion hole 413, and the first concave-convex structure 414 may be formed in the screw head 411. The screw groove 412 may be a groove into which a tool for rotating the first screw 410 is inserted. The screw groove 412 may be formed by being recessed from the screw head 411 by a designated depth (e.g., a depth in a z direction). For example, the screw groove 412 may be formed in a "+" or "-" shape. However, this is an example, and the shape of the screw groove 412 is not limited thereto.

In an embodiment, the second screw insertion hole 413 may be formed in the screw head 411 of the first screw 410. The second screw insertion hole 413 may be formed substantially near the center of the screw head 411. For example, the second screw insertion hole 413 may be formed by being recessed from the screw head 411 by a designated depth (e.g., a depth in a -z direction). For example, the second screw insertion hole 413 may be formed to have a size corresponding to that of the second screw 420.

In an embodiment, the first concave-convex structure 414 may be formed in the screw head 411 of the first screw 410. The first concave-convex structure 414 may be formed around the second screw insertion hole 413. The first concave-convex structure 414 may be formed in plurality. For example, a plurality of first concave-convex structures 414 may be formed around the second screw insertion hole 413 along the circumference of the screw head 411. The first concave-convex structure 414 may include a concave-convex shape. For example, the first concave-convex structure 414 may be formed by protruding and/or being recessed in a circular, triangular, rectangular, or any polygonal shape. For example, as shown in FIG. 4B, the first concave-convex structure 414 may include a shape that is recessed from the screw head 411 by a designated depth (e.g., the depth in the z direction). However, the first concave-convex structure 414 illustrated in the drawing is an example, and the number, position, and/or shape of the first concave-convex structure 414 are not limited thereto. For example, the first concave-convex structure 414 may include a shape protruding from the screw head 411 by a designated height (e.g., a height in a z direction).

Referring to FIGS. 4C, 4D, 4F, and 4G, in an embodiment, the heat dissipation member 430 may be disposed on the target component 320 in a state in which the target component 320 (e.g., the audio module 320a and/or the PCB 320b) is fixed to the first housing 311.

In an embodiment, the heat dissipation member 430 may include a main heat dissipation body 431 and an extended heat dissipation body 432.

In an embodiment, the main heat dissipation body 431 may be a part positioned adjacent to or in contact with a heat-generating component. For example, the main heat dissipation body 431 may be positioned adjacent to or in contact with any component disposed in the PCB 320b. For example, the main heat dissipation body 431 may be formed substantially in a plate shape. However, this is an example, and the position and/or shape of the main heat dissipation body 431 is not limited thereto.

In an embodiment, the extended heat dissipation body 432 may be a part extending from the main heat dissipation body 431. The extended heat dissipation body 432 may be a part in contact with the second housing 312. At least one extended heat dissipation body 432 may be formed. The extended heat dissipation body 432 may be formed in a number corresponding to that of the first screw 410. For example, the extended heat dissipation body 432 may be positioned between the screw head 411 of the first screw 410 and the second housing 312. For example, one surface (e.g., a surface in a +z direction) of the extended heat dissipation body 432 may contact the second housing 312, and the other surface (e.g., a surface in a -z direction) may face the screw head 411 of the first screw 410. A hole through which the second screw 420 penetrates may be formed in the extended heat dissipation body 432.

In an embodiment, the concave-convex member 440 may be positioned in the other surface (e.g., the surface in the -z direction) of the extended heat dissipation body 432. For example, the concave-convex member 440 may be attached to the other surface (e.g., the surface in the -z direction) of the extended heat dissipation body 432 by welding. However, this is an example, and the method of positioning the concave-convex member 440 in the extended heat dissipation body 432 is not limited thereto.

In an embodiment, the concave-convex member 440 may include a main body 441, a through hole 442, and a second concave-convex structure 443. The main body 441 may be formed substantially in a plate shape. The through hole 442 may be formed by penetrating the main body 441. The through hole 442 may be formed substantially near the center of the main body 441. The through hole 442 may be a hole through which the second screw 420 penetrates.

In an embodiment, the second concave-convex structure 443 may be formed in the main body 441. The second concave-convex structure 443 may be formed around the through hole 442. The second concave-convex structure 443 may be formed in plurality. For example, the plurality of second concave-convex structures 443 may be formed around the through hole 442 along the circumference of the main body 441. The second concave-convex structure 443 may include a concave-convex shape corresponding to a first concave-convex structure (e.g., the first concave-convex structure 414 of FIG. 4B). For example, the second concave-convex structure 443 may be formed by protruding and/or being recessed in a circular, triangular, rectangular, or any polygonal shape. For example, as shown in FIG. 4D, the second concave-convex structure 443 may include a shape protruding from the main body 441 by a designated height (e.g., a height in a z direction). However, the second concave-convex structure 443 illustrated in the drawing is an example, and the number, position, and/or shape of the second concave-convex structure 443 are not limited thereto. For example, the second concave-convex structure 443 may also include a shape that is recessed from the main body 441 by a designated depth (e.g., a depth in a z direction).

Referring to FIGS. 4E to 4G, in an embodiment, the second housing 312 may be positioned on the heat dissipation member 430 in a state in which the heat dissipation member 430 is positioned on the target component 320. In a state in which the second housing 312 is positioned on the heat dissipation member 430, the second screw 420 may be inserted into the second screw insertion hole 413 formed in the first screw 410 by penetrating the second housing 312 and the heat dissipation member 430. The second screw 420 may penetrate the second housing 312 and the heat dissipation member 430 and be inserted into the second screw insertion hole 413 such that the second housing 312 and the heat dissipation member 430 are fixed to the first housing 311.

In an embodiment, by the first screw 410 and the second screw 420, the second concave-convex structure 443 may be positioned between the screw head 411 of the first screw 410 and the second housing 312 in a state in which the first housing 311, the target component 320, the heat dissipation member 430, and the second housing 312 are fastened to each other. For example, the first concave-convex structure 414 and the second concave-convex structure 443 may be positioned to face each other. As shown in FIGS. 4F and 4G, the first concave-convex structure 414 and the second concave-convex structure 443 may be positioned to be spaced apart from each other by a designated distance d1 in a state in which the first screw 410 is completely inserted into the first screw insertion hole 3111.

In an embodiment, like the state in FIG. 4E, a display (e.g., the display 330 of FIG. 3), a front plate (e.g., the front plate 313 of FIG. 3), and/or a wheel key (e.g., the wheel key 314 of FIG. 3) may be positioned on the second housing 312. In a state in which an electronic device (e.g., the electronic device 300 of FIG. 3) is completely assembled, the first screw 410 and the second screw 420 may be positioned inside a space defined by the first housing 311, the second housing 312, and the front plate 313. According to this structure, in a state in which the electronic device 300 is completely assembled, the first screw 410 and the second screw 420 may not be exposed to the outside of the electronic device 300.

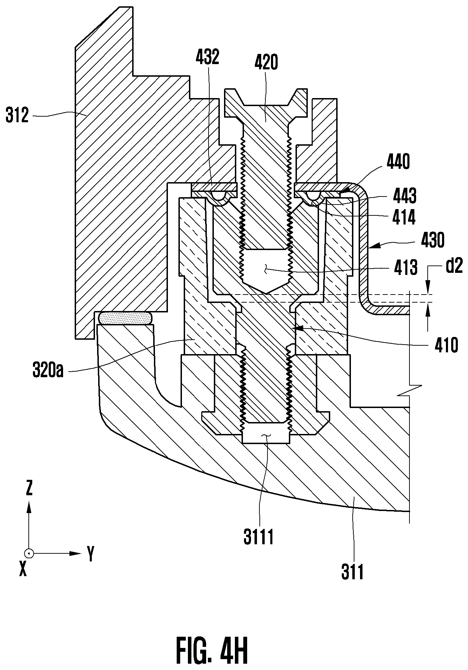

FIG. 4H illustrates a state in which a second screw and a first screw are each dismantled by a predetermined length in the state of FIG. 4F, according to an embodiment.

Hereinafter, a principle that further rotation of the first screw 410 is limited when the first screw 410 is dismantled by a designated length d2 in a process in which the second screw 420 is dismantled from the second screw insertion hole 413 is described with reference to FIGS. 4F and 4H.

In an embodiment, to repair or inspect an electronic device (e.g., the electronic device 300 of FIG. 3), a worker may disassemble the electronic device 300. The worker may open the inside of the electronic device 300 by removing a front plate (e.g., the front plate 313 of FIG. 3) and/or a display (e.g., the display 330 of FIG. 3) of the electronic device 300 from the second housing 312. The worker may rotate and dismantle the second screw 420 from the second screw insertion hole 413 to separate the second housing 312 and/or the heat dissipation member 430 from the first housing 311. During the process of rotating the second screw 420, the first screw 410 may be rotated together with the second screw 420 by the fastening force between the second screw 420 and the second screw insertion hole 413. When the first screw 410 is rotated together with the second screw 420, the first screw 410 may start to be dismantled from the first screw insertion hole 3111. In this process, when the first screw 410 is dismantled from the first screw insertion hole 3111 by the designated length d2, the first concave-convex structure 414 and the second concave-convex structure 443 may be engaged with each other. For example, as shown in FIG. 4G, when the first screw 410 is dismantled from the first screw insertion hole 3111 by the designated length d2, the first concave-convex structure 414 rises in the +z direction so that the first concave-convex structure 414 and the second concave-convex structure 443 may be engaged with each other. In this state, when the second screw 420 is rotated, even when the rotational force is transmitted to the first screw 410 by the fastening force between the second screw 420 and the second screw insertion hole 413, since the first concave-convex structure 414 and the second concave-convex structure 443 are engaged with each other, further rotation of the first screw 410 may be limited. Accordingly, in the state in which the first concave-convex structure 414 and the second concave-convex structure 443 are engaged with each other, when the worker rotates the second screw 420, the rotation of the first screw 410 may be limited, and only the second screw 420 may be rotated. As a result, the worker may completely dismantle the second screw 420 from the second screw insertion hole 413 while maintaining the fastening between the first screw 410 and the first screw insertion hole 3111. To reassemble the electronic device 300, the worker may completely fasten the first screw 410 to the first screw insertion hole 3111 by rotating again the first screw 410 of which the fastening is dismantled by the designated length d2 after removing the heat dissipation member 430. Thereafter, the worker may fix the heat dissipation member 430 and the second housing 312 to the first housing 311 using the second screw 420.

In an embodiment, the distance d1 at which the first concave-convex structure 414 and the second concave-convex structure 443 are spaced apart from each other in a state in which the first screw 410 is completely fastened to the first screw insertion hole 3111 may be substantially the same as the length d2 at which the first screw 410 is dismantled from the first screw insertion hole 3111 so that the first concave-convex structure 414 and the second concave-convex structure 443 are engaged with each other. The distance d1 at which the first concave-convex structure 414 and the second concave-convex structure 443 are spaced apart from each other in a state in which the first screw 410 is completely fastened to the first screw insertion hole 3111 may be less than a length required for the first screw 410 to be completely dismantled from the first screw insertion hole 3111. According to this structure, in a process in which the second screw 420 is dismantled from the second screw insertion hole 413, the first concave-convex structure 414 and the second concave-convex structure 443 may be engaged with each other before the first screw 410 is completely dismantled from the first screw insertion hole 3111. As described above, the dismantling process of the first screw 410 and the second screw 420 is described with reference to FIGS. 4F and 4H in which the audio module 320a is illustrated, but this is for the ease of description, and it will be obvious to one of ordinary skill in the art that the process described above may be substantially equally applied to the case of FIG. 4G in which the PCB 320b is illustrated. It will be obvious to one of ordinary skill in the art that the structure of the first screw 410 and the second screw 420 described above is not limited to the audio module 320a and the PCB 320b illustrated in the drawing and may be substantially equally applied to any target component 320.

In addition, although the concave-convex member 440 in which the second concave-convex structure 443 is formed is illustrated and described as being attached to the other surface (e.g., the surface in the -z direction) of the extended heat dissipation body 432, this is an example, and the position in which the second concave-convex structure 443 is formed is not limited thereto. For example, the second concave-convex structure 443 may be formed directly in the other surface (e.g., the surface in the -z direction) of the extended heat dissipation body 432. For example, the second concave-convex structure 443 may be formed in any member positioned between the screw head 411 of the first screw 410 and the second housing 312. For example, the second concave-convex structure 443 may be directly formed in the extended heat dissipation body 432 through injection molding and/or etching molding (e.g., computer numerical control (CNC) machining). However, this is an example, and the method in which the second concave-convex structure 443 is directly formed in the extended heat dissipation body 432 is not limited thereto.

Although an electronic device is described as a wearable electronic device in FIGS. 2A, 2B, and 3, and FIGS. 4A to 4H, this is an example, and the structure described above may be applied to various electronic devices.

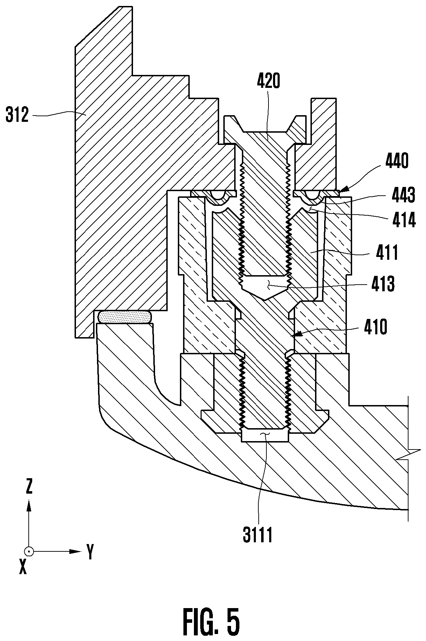

FIG. 5 is a cross-sectional view of an electronic device according to an embodiment.

In describing an electronic device according to FIG. 5, a detailed description of a configuration that is substantially the same as that of the electronic device described above with reference to FIG. 3 and FIGS. 4A to 4H is omitted.

Referring to FIG. 5, in an embodiment, the second concave-convex structure 443 may be positioned in a surface (e.g., a surface in a -z direction) of the second housing 312 facing the screw head 411 of the first screw 410. For example, the concave-convex member 440 in which the second concave-convex structure 443 is formed may be attached to the surface (e.g., the surface in the -z direction) of the second housing 312 facing the screw head 411 of the first screw 410 through welding. However, this is an example, and the method of positioning the concave-convex member 440 in the second housing 312 is not limited thereto. In addition, although the concave-convex member 440 in which the second concave-convex structure 443 is formed is illustrated and described as being attached to the second housing 312, this is an example, and the position in which the second concave-convex structure 443 is formed is not limited thereto. For example, the second concave-convex structure 443 may be directly formed in the surface (e.g., the surface in the -z direction) of the second housing 312 facing the screw head 411 of the first screw 410. For example, the second concave-convex structure 443 may be directly formed in the second housing 312 through injection molding and/or etching molding (e.g., CNC machining). However, this is an example, and the method in which the second concave-convex structure 443 is directly formed in the second housing 312 is not limited thereto.

Substantially the same principle as described with reference to FIGS. 4A to 4H may also be applied to the structure shown in FIG. 5. For example, in the process in which the second screw 420 is dismantled from the second screw insertion hole 413, the first concave-convex structure 414 and the second concave-convex structure 443 may be engaged with each other before the first screw 410 is completely dismantled from the first screw insertion hole 3111. Accordingly, the worker may completely dismantle the second screw 420 from the second screw insertion hole 413 while maintaining the fastening between the first screw 410 and the first screw insertion hole 3111.

In an embodiment, the electronic device 300 may include the first housing 311 in which the first screw insertion hole 3111 is formed, the second housing 312 capable of being fastened to the first housing 311, the first screw 410 including the head 411, the second screw insertion hole 413 formed in the head 411, and the first concave-convex structure 414 formed around the second screw insertion hole 413 and configured to penetrate the target component 320 and be inserted into the first screw insertion hole 3111 to fix the target component 320 to the first housing 311, the second screw 420 configured to penetrate the second housing 312 and be inserted into the second screw insertion hole 413 to fix the second housing 312 to the first housing 311, and the second concave-convex structure 443 positioned between the head 411 of the first screw 410 and the second housing 312 and corresponding to the first concave-convex structure 414.

In an embodiment, the first concave-convex structure 414 and the second concave-convex structure 443 may be positioned spaced apart from each other in a state in which the first screw 410 is completely fastened to the first screw insertion hole 3111.

In an embodiment, the first concave-convex structure 414 and the second concave-convex structure 443 may be engaged with each other when the first screw 410 is dismantled from the first screw insertion hole 3111 by a designated length.

In an embodiment, the rotation of the first screw 410 may be limited in a state in which the first concave-convex structure 414 and the second concave-convex structure 443 are engaged with each other. A worker may completely dismantle the second screw 420 from the second screw insertion hole 413 while maintaining the fastening between the first screw 410 and the first screw insertion hole 3111.

In an embodiment, a distance at which the first concave-convex structure 414 and the second concave-convex structure 443 are spaced apart from each other in a state in which the first screw 410 is completely fastened to the first screw insertion hole 3111 may be less than a length required for the first screw 410 to be completely dismantled from the first screw insertion hole 3111.

In an embodiment, the electronic device 300 may further include the heat dissipation member 430 configured to dissipate heat inside the electronic device 300 outwardly.

In an embodiment, the heat dissipation member 430 may include the main heat dissipation body 431 and the extended heat dissipation body 432 extending from the main heat dissipation body 431 and positioned between the head 411 of the first screw 410 and the second housing 312.

In an embodiment, the extended heat dissipation body 432 may be disposed such that one surface contacts the second housing 312 and another surface faces the head 411 of the first screw 410.

In an embodiment, the concave-convex member 440 in which the second concave-convex structure 443 is formed may be positioned in the other surface of the extended heat dissipation body 432.

In an embodiment, the second concave-convex structure 443 may be formed in the other surface of the extended heat dissipation body 432.

In an embodiment, the concave-convex member 440 in which the second concave-convex structure 443 is formed may be positioned in a surface of the second housing 312 facing the head 411 of the first screw 410.

In an embodiment, the second concave-convex structure 443 may be formed in the surface of the second housing 312 facing the head 411 of the first screw 410.

In an embodiment, the first screw insertion hole 3111 may be positioned inside a space defined by the first housing 311 and the second housing 312.

In an embodiment, the electronic device 300 may further include the front plate 313 connected to the second housing 312.

In an embodiment, the first screw 410 and the second screw 420 may be positioned inside a space defined by the first housing 311, the second housing 312, and the front plate 313 and may not be exposed to the outside of the electronic device 300.

In an embodiment, the wearable electronic device 300 may include the first housing 311 in which the first screw insertion hole 3111 is formed and configured to form a rear surface of the electronic device 300, the second housing 312 capable of being fastened to the first housing 311 and configured to form a side surface of the electronic device 300, the front plate 313 connected to the second housing 312 and configured to form a front surface of the electronic device 300, the first screw 410 including the head 411, the second screw insertion hole 413 formed in the head 411, and the first concave-convex structure 414 formed around the second screw insertion hole 413 and configured to penetrate the target component 320 and be inserted into the first screw insertion hole 3111 to fix the target component 320 to the first housing 311, the second screw 420 configured to penetrate the second housing 312 and be inserted into the second screw insertion hole 413 to fix the second housing 312 to the first housing 311, and the second concave-convex structure 443 positioned between the head 411 of the first screw 410 and the second housing 312 and corresponding to the first concave-convex structure 414.

In an embodiment, the first concave-convex structure 414 and the second concave-convex structure 443 may be positioned spaced apart from each other in a state in which the first screw 410 is completely fastened to the first screw insertion hole 3111.

In an embodiment, the rotation of the first screw 410 may be limited in a state in which the first concave-convex structure 414 and the second concave-convex structure 443 are engaged with each other when the first screw 410 is dismantled from the first screw insertion hole 3111 by a designated length.

In an embodiment, the first screw 410 and the second screw 420 may be positioned inside a space defined by the first housing 311, the second housing 312, and the front plate 313 and may not be exposed to the outside of the wearable electronic device 300.

In an embodiment, the electronic device 300 may include the first housing 311 in which the first screw insertion hole 3111 is formed, the second housing 312 capable of being fastened to the first housing 311, the first screw 410 including the head 411, the second screw insertion hole 413 formed in the head 411, and the first concave-convex structure 414 formed around the second screw insertion hole 413 and configured to penetrate the target component 320 and be inserted into the first screw insertion hole 3111 to fix the target component 320 to the first housing 311, the second screw 420 configured to penetrate the second housing 312 and be inserted into the second screw insertion hole 413 to fix the second housing 312 to the first housing 311, the heat dissipation member 430 including the main heat dissipation body 431 and the extended heat dissipation body 432 extending from the main heat dissipation body 431 and disposed such that one surface contacts the second housing 312 and another surface faces the head 411 of the first screw 410, the second concave-convex structure 443 corresponding to the first concave-convex structure 414, and the concave-convex member 440 positioned in the other surface of the extended heat dissipation body 432. The first concave-convex structure 414 and the second concave-convex structure 443 may be positioned spaced apart from each other in a state in which the first screw 410 is completely fastened to the first screw insertion hole 3111. The rotation of the first screw 410 may be limited in a state in which the first concave-convex structure 414 and the second concave-convex structure 443 are engaged with each other when the first screw 410 is dismantled from the first screw insertion hole 3111 by a designated length.

## Claims

1. An electronic device (300) comprising:
a first housing (311) in which a first screw insertion hole (3111) is formed;
a second housing (312) capable of being fastened to the first housing (311);
a first screw (410) comprising a head (411), a second screw insertion hole (413) formed in the head (411), and a first concave-convex structure (414) formed around the second screw insertion hole (413) and configured to penetrate a target component (320) and be inserted into the first screw insertion hole (3111) to fix the target component (320) to the first housing (311);
a second screw (420) configured to penetrate the second housing (312) and be inserted into the second screw insertion hole (413) to fix the second housing (312) to the first housing (311); and
a second concave-convex structure (443) positioned between the head (411) of the first screw (410) and the second housing (312) and corresponding to the first concave-convex structure (414),
wherein the first concave-convex structure (414) and the second concave-convex structure (443) are positioned spaced apart from each other in a state in which the first screw (410) is completely fastened to the first screw insertion hole (3111), and
wherein the first concave-convex structure (414) and the second concave-convex structure (443) are engaged with each other when the first screw (410) is dismantled from the first screw insertion hole (3111) by a designated length.

2. The electronic device (300) of claim 1, wherein rotation of the first screw (410) is limited in a state in which the first concave-convex structure (414) and the second concave-convex structure (443) are engaged with each other.

3. The electronic device (300) of claim 1 or 2, wherein a distance at which the first concave-convex structure (414) and the second concave-convex structure (443) are spaced apart from each other in the state in which the first screw (410) is completely fastened to the first screw insertion hole (3111) is less than a length required for the first screw (410) to be completely dismantled from the first screw insertion hole (3111).

4. The electronic device (300) of one of claims 1 to 3, further comprising:
a heat dissipation member (430) configured to dissipate heat inside the electronic device (300) outwardly.

5. The electronic device (300) of claim 4, wherein the heat dissipation member (430) comprises:
a main heat dissipation body (431); and
an extended heat dissipation body (432) extending from the main heat dissipation body (431) and positioned between the head (411) of the first screw (410) and the second housing (312).

6. The electronic device (300) of claim 5, wherein the extended heat dissipation body (432) is disposed such that one surface contacts the second housing (312) and another surface faces the head (411) of the first screw (410).

7. The electronic device (300) of claim 6, wherein a concave-convex member (440) in which the second concave-convex structure (443) is formed is positioned in the other surface of the extended heat dissipation body (432).

8. The electronic device (300) of claim 6 or 7, wherein the second concave-convex structure (443) is formed in the other surface of the extended heat dissipation body (432).

9. The electronic device (300) of one of claims 1 to 8, wherein the concave-convex member (440) in which the second concave-convex structure (443) is formed is positioned in a surface of the second housing (312) facing the head (411) of the first screw (410).

10. The electronic device (300) of one of claims 1 to 9, wherein the second concave-convex structure (443) is formed in the surface of the second housing (312) facing the head (411) of the first screw (410).

11. The electronic device (300) of one of claims 1 to 10, wherein the first screw insertion hole (3111) is positioned inside a space defined by the first housing (311) and the second housing (312).

12. The electronic device (300) of one of claims 1 to 11, further comprising:
a front plate (313) connected to the second housing (312).

13. The electronic device (300) of one of claims 1 to 12, wherein the first screw (410) and the second screw (420) are positioned inside a space defined by the first housing (311), the second housing (312), and the front plate (313) and are not exposed to an outside of the electronic device (300).

## Patentansprüche

1. Elektronische Vorrichtung (300), umfassend:
ein erstes Gehäuse (311), in dem ein erstes Schraubeneinführloch (3111) gebildet ist;
ein zweites Gehäuse (312), das in der Lage ist, an dem ersten Gehäuse (311) befestigt zu werden;
eine erste Schraube (410), die einen Kopf (411), ein zweites Schraubeneinführloch (413), das in dem Kopf (411) gebildet ist, und eine erste konkav-konvexe Struktur (414), die um das zweite Schraubeneinführloch (413) gebildet und dazu konfiguriert ist, eine Zielkomponente (320) zu durchdringen und in das erste Schraubeneinführloch (3111) eingeführt zu werden, um die Zielkomponente (320) an dem ersten Gehäuse (311) zu fixieren, umfasst;
eine zweite Schraube (420), die dazu konfiguriert ist, das zweite Gehäuse (312) zu durchdringen und in das zweite Schraubeneinführloch (413) eingeführt zu werden, um das zweite Gehäuse (312) an dem ersten Gehäuse (311) zu fixieren; und
eine zweite konkav-konvexe Struktur (443), die zwischen dem Kopf (411) der ersten Schraube (410) und dem zweiten Gehäuse (312) positioniert ist und der ersten konkav-konvexen Struktur (414) entspricht,
wobei die erste konkav-konvexe Struktur (414) und die zweite konkav-konvexe Struktur (443) in einem Zustand, in dem die erste Schraube (410) vollständig an dem ersten Schraubeneinführloch (3111) befestigt ist, voneinander beabstandet positioniert sind, und
wobei die erste konkav-konvexe Struktur (414) und die zweite konkav-konvexe Struktur (443) miteinander eingegriffen sind, wenn die erste Schraube (410) um eine festgelegte Länge von dem ersten Schraubeneinführloch (3111) demontiert ist.

2. Elektronische Vorrichtung (300) nach Anspruch 1, wobei Drehung der ersten Schraube (410) in einem Zustand begrenzt ist, in dem die erste konkav-konvexe Struktur (414) und die zweite konkav-konvexe Struktur (443) miteinander eingegriffen sind.

3. Elektronische Vorrichtung (300) nach Anspruch 1 oder 2, wobei ein Abstand, in dem die erste konkav-konvexe Struktur (414) und die zweite konkav-konvexe Struktur (443) in dem Zustand, in dem die erste Schraube (410) vollständig an dem ersten Schraubeneinführloch (3111) befestigt ist, voneinander beabstandet sind, geringer als eine Länge ist, die erforderlich ist, damit die erste Schraube (410) vollständig von dem ersten Schraubeneinführloch (3111) demontiert werden kann.

4. Elektronische Vorrichtung (300) nach einem der Ansprüche 1 bis 3, ferner umfassend:
ein Wärmeableitungselement (430), das dazu konfiguriert ist, Wärme innerhalb der elektronischen Vorrichtung (300) nach außen abzuleiten.

5. Elektronische Vorrichtung (300) nach Anspruch 4, wobei das Wärmeableitungselement (430) Folgendes umfasst:
einen Hauptwärmeableitungskörper (431); und
einen erweiterten Wärmeableitungskörper (432), der sich von dem Hauptwärmeableitungskörper (431) erstreckt und zwischen dem Kopf (411) der ersten Schraube (410) und dem zweiten Gehäuse (312) positioniert ist.

6. Elektronische Vorrichtung (300) nach Anspruch 5, wobei der erweiterte Wärmeableitungskörper (432) angeordnet ist, sodass eine Oberfläche das zweite Gehäuse (312) kontaktiert und eine andere Oberfläche dem Kopf (411) der ersten Schraube (410) zugewandt ist.

7. Elektronische Vorrichtung (300) nach Anspruch 6, wobei ein konkav-konvexes Element (440), in dem die zweite konkav-konvexe Struktur (443) gebildet ist, in der anderen Oberfläche des erweiterten Wärmeableitungskörpers (432) positioniert ist.

8. Elektronische Vorrichtung (300) nach Anspruch 6 oder 7, wobei die zweite konkav-konvexe Struktur (443) in der anderen Oberfläche des erweiterten Wärmeableitungskörpers (432) gebildet ist.

9. Elektronische Vorrichtung (300) nach einem der Ansprüche 1 bis 8, wobei das konkav-konvexe Element (440), in dem die zweite konkav-konvexe Struktur (443) gebildet ist, in einer Oberfläche des zweiten Gehäuses (312) positioniert ist, die dem Kopf (411) der ersten Schraube (410) zugewandt ist.

10. Elektronische Vorrichtung (300) nach einem der Ansprüche 1 bis 9, wobei die zweite konkav-konvexe Struktur (443) in der Oberfläche des zweiten Gehäuses (312) gebildet ist, die dem Kopf (411) der ersten Schraube (410) zugewandt ist.

11. Elektronische Vorrichtung (300) nach einem der Ansprüche 1 bis 10, wobei das erste Schraubeneinführloch (3111) innerhalb eines Raums positioniert ist, der durch das erste Gehäuse (311) und das zweite Gehäuse (312) definiert ist.

12. Elektronische Vorrichtung (300) nach einem der Ansprüche 1 bis 11, ferner umfassend:
eine Frontplatte (313), die mit dem zweiten Gehäuse (312) verbunden ist.

13. Elektronische Vorrichtung (300) nach einem der Ansprüche 1 bis 12, wobei die erste Schraube (410) und die zweite Schraube (420) innerhalb eines Raums positioniert sind, der durch das erste Gehäuse (311), das zweite Gehäuse (312) und die Frontplatte (313) definiert ist, und nicht einer Außenseite der elektronischen Vorrichtung (300) ausgesetzt sind.

## Revendications

1. Dispositif électronique (300) comprenant :
un premier boîtier (311) dans lequel un premier trou d'insertion (3111) de vis est formé ;
un second boîtier (312) pouvant être fixé au premier boîtier (311) ;
une première vis (410) comprenant une tête (411), un second trou d'insertion (413) de vis formé dans la tête (411), et une première structure concave-convexe (414) formée autour du second trou d'insertion (413) de vis et conçue pour pénétrer dans un composant cible (320) et être insérée dans le premier trou d'insertion (3111) de vis pour fixer le composant cible (320) au premier boîtier (311) ;
une seconde vis (420) configurée pour pénétrer dans le second boîtier (312) et être insérée dans le second trou d'insertion (413) de vis pour fixer le second boîtier (312) au premier boîtier (311) ; et
une seconde structure concave-convexe (443) positionnée entre la tête (411) de la première vis (410) et le second boîtier (312) et correspondant à la première structure concave-convexe (414),
ladite première structure concave-convexe (414) et ladite seconde structure concave-convexe (443) étant positionnées espacées l'une de l'autre dans un état dans lequel la première vis (410) est complètement fixée au premier trou d'insertion (3111) de vis, et
ladite première structure concave-convexe (414) et ladite seconde structure concave-convexe (443) étant en prise l'une avec l'autre lorsque la première vis (410) est démontée du premier trou d'insertion (3111) de vis d'une longueur désignée.

2. Dispositif électronique (300) de la revendication 1, ladite rotation de la première vis (410) étant limitée dans un état dans lequel ladite première structure concave-convexe (414) et ladite seconde structure concave-convexe (443) sont en prise l'une avec l'autre.

3. Dispositif électronique (300) de la revendication 1 ou 2, une distance à laquelle la première structure concave-convexe (414) et la seconde structure concave-convexe (443) sont espacées l'une de l'autre dans l'état dans lequel la première vis (410) est complètement fixée au premier trou d'insertion (3111) de vis est inférieure à une longueur requise pour que la première vis (410) soit complètement démontée du premier trou d'insertion (3111) de vis.

4. Dispositif électronique (300) de l'une des revendications 1 à 3, comprenant en outre :
un élément de dissipation de chaleur (430) conçu pour dissiper la chaleur à l'intérieur du dispositif électronique (300) vers l'extérieur.

5. Dispositif électronique (300) de la revendication 4, ledit élément de dissipation de chaleur (430) comprenant :
un corps principal de dissipation de chaleur (431) ; et
un corps de dissipation de chaleur étendu (432) s'étendant à partir du corps principal de dissipation de chaleur (431) et positionné entre la tête (411) de la première vis (410) et le second boîtier (312).

6. Dispositif électronique (300) de la revendication 5, ledit corps de dissipation de chaleur étendu (432) étant disposé de sorte qu'une surface entre en contact avec le second boîtier (312) et une autre surface fasse face à la tête (411) de la première vis (410).

7. Dispositif électronique (300) de la revendication 6, un élément concave-convexe (440) dans lequel la seconde structure concave-convexe (443) est formée étant positionné dans l'autre surface du corps de dissipation de chaleur étendu (432).

8. Dispositif électronique (300) de la revendication 6 ou 7, ladite seconde structure concave-convexe (443) étant formée dans l'autre surface du corps de dissipation de chaleur étendu (432).

9. Dispositif électronique (300) de l'une des revendications 1 à 8, ledit élément concave-convexe (440) dans lequel la seconde structure concave-convexe (443) est formée étant positionné dans une surface du second boîtier (312) faisant face à la tête (411) de la première vis (410).

10. Dispositif électronique (300) de l'une des revendications 1 à 9, ladite seconde structure concave-convexe (443) étant formée dans la surface du second boîtier (312) faisant face à la tête (411) de la première vis (410).

11. Dispositif électronique (300) de l'une des revendications 1 à 10, ledit premier trou d'insertion (3111) de vis étant positionné à l'intérieur d'un espace défini par le premier boîtier (311) et le second boîtier (312).

12. Dispositif électronique (300) de l'une des revendications 1 à 11, comprenant en outre : une plaque avant (313) reliée au second boîtier (312).

13. Dispositif électronique (300) de l'une des revendications 1 à 12, ladite première vis (410) et la seconde vis (420) étant positionnées à l'intérieur d'un espace défini par le premier boîtier (311), le second boîtier (312) et la plaque avant (313) et n'étant pas exposées à un extérieur du dispositif électronique (300).
